**Europäisches Patentamt**

**European Patent Office**

**Office européen des brevets**

(11) Veröffentlichungsnummer: **0 148 461**
**B1**

# EUROPÄISCHE PATENTSCHRIFT

(45) Veröffentlichungstag der Patentschrift:
**10.08.88**

(21) Anmeldenummer: **84115598.9**

(22) Anmeldetag: **17.12.84**

(51) Int. Cl.⁴: **H 01 R 9/09,** H 05 K 7/10

(54) **Verfahren zur Herstellung einer Schichtschaltung mit Anschlussklemmen.**

(30) Priorität: **20.12.83 DE 3345993**

(43) Veröffentlichungstag der Anmeldung:
**17.07.85 Patentblatt 85/29**

(45) Bekanntmachung des Hinweises auf die Patenterteilung:
**10.08.88 Patentblatt 88/32**

(84) Benannte Vertragsstaaten:
**CH DE FR GB IT LI**

(56) Entgegenhaltungen:
**EP-A-0 040 942**
**DE-A-2 321 828**
**DE-A-2 841 665**
**FR-A-2 424 689**

(73) Patentinhaber: **Siemens Aktiengesellschaft Berlin und München, Wittelsbacherplatz 2, D-8000 München 2 (DE)**

(72) Erfinder: **Drekmeier, Karl Gerd, Bussardstrasse 42, D-8025 Unterhaching (DE)**

EP 0 148 461 B1

LIBER, STOCKHOLM 1988

## Beschreibung

Die Erfindung bezieht sich auf ein Verfahren zur Herstellung einer Schichtschaltung, bei der eine Vielzahl von Anschlußklemmen, die zu einem Trägerstreifen zusammengefaßt sind, zunächst auf einer Seite über eine taschenförmige Klemmkontur mit Anschlußflächen der Schichtschaltung verbunden und anschließend auf der anderen Seite mit im Anschluß an eine Verbreiterung vorgesehenen bandförmigen, vergleichsweise schmaleren Anschlußstücken in Rasterbohrungen einer Leiterplatte eingesteckt werden, nachdem zuvor ein Steg, über den die Anschlußstücke im Rasterabstand zusammenhängen, abgetrennt worden ist.

Ein solches Verfahren ist schon aus der DE-A-2 321 828 bekannt und ermöglicht es, die einzelnen Anschlußstücke bis zur Verbindung der Anschlußklemmen mit der Schichtschaltung genau im Rastermaß der Bohrungen einer Leiterplatte, in die die Anschlußstücke eingesteckt werden sollen, festzuhalten. Bei den aus diesem Verfahren bekannten Anschlußklemmen haben die Anschlußstücke jedoch nur einen geraden Verlauf, so daß es entweder erforderlich ist, die Breite der Anschlußstücke genau dem Durchmesser der Rasterbohrungen der Leiterplatte anzupassen oder andere Hilfsmittel vorzusehen, damit die Anschlußstücke beim Schwallöten nicht wieder aus den Rasterbohrungen der Leiterplatte herausgedrückt werden können.

Deshalb ist es Aufgabe vorliegender Erfindung, ein Verfahren der eingangs genannten Art derart weiterzubilden, daß mit dessen Hilfe Anschlußstücke erhalten werden, die der Schichtschaltung schon vor dem Verlöten und besonders bei dem Verlöten der Anschlußstücke mit der Leiterplatte ausreichenden Halt an der Leiterplatte bieten, jedoch vergleichsweise wenig aufwendig herstellbar sind.

Erfindungsgemäß wird diese Aufgabe dadurch gelöst, daß wenigstens einige der Anschlußstücke nach dem Abtrennen des Steges derart umgebogen werden, daß eine V-förmige Feder entsteht, deren freier Schenkel mit seinem Ende oberhalb einer als Anschlag beim Einstecken der Anschlußstücke in die Bohrungen einer Leiterplatte wirksamen Schulterkante der Verbreiterung der Anschlußklemmen liegt.

Auf diese Weise kann durch Wahl der Anzahl der mit der V-förmigen Feder im Bereich ihrer Anschlußstücke versehenen Anschlußklemmen die Kraft variiert werden, mit der die Schichtschaltung an der Leiterplatte gehalten wird, ohne daß die Kraft, mit der die Anschlußstücke in die Bohrungen der Leiterplatte eingedrückt werden müssen, zu hoch wird.

Zwar ist schon aus der EP-A-0 040 942 eine Anschlußklemme bekannt, bei der im Bereich des Anschlußstückes ebenfalls eine V-förmige Feder vorhanden ist, deren freier Schenkel über einen Anschlag hinausragt, der die Einstecktiefe des Anschlußstückes in einer Rasterbohrung der Leiterplatte begrenzt und dadurch das Wiederherausziehen des Anschlußstückes aus der Rasterbohrung erleichtert. Jedoch wird der freie Schenkel des Anschlußstückes bei dieser bekannten Anschlußklemme durch einen schmaleren Freischnitt aus der Gesamtbreite des Anschlußstückes erhalten, und nicht durch eine V-förmige Biegung, so daß eine Materialschwächung des in seiner Gesamtbreite durch den Bohrungsdurchmesser begrenzten Anschlußstückes in Kauf genommen werden muß. Darüber hinaus besteht die bekannte Anschlußklemme jeweils aus zwei Teilen, die zusammengesteckt werden müssen, wodurch im Zuge der Anschlußklemme zusätzliche Kontaktstellen gebildet werden.

Die Erfindung wird nachfolgend anhand von acht Figuren noch näher erläutert.

Dabei zeigen,

FIG 1 und FIG 2 einen Trägerstreifen mit einer Mehrzahl von Anschlußklemmen in fester Verbindung mit einer Schichtschaltung in Aufsicht und

FIG 3 einen Teil einer Schichtschaltung mit einer einzelnen Anschlußklemme mit V-förmig gebogenem Anschlußstück,

FIG 4 eine Schichtschaltung mit einer Mehrzahl von Anschlußklemmen, von denen einige V-förmig umgebogen sind,

FIG 5 in Seitenansicht eine in eine Leiterplatte eingesetzte Schichtschaltung mit zwei Reihen von Anschlußklemmen,

FIG 6 die Seitenansicht eines federnden Anschlußstückes in einem Leiterplattenloch bzw. in einer Leiterplattenbohrung vor dem Verlöten,

FIG 7 die Darstellung der Hauptkontaktstellen zwischen einer Anschlußklemme und einem Leiterplattenloch bzw. einer Leiterplattenbohrung und

FIG 8 das, was FIG 6 zeigt, jedoch im verlöteten Zustand.

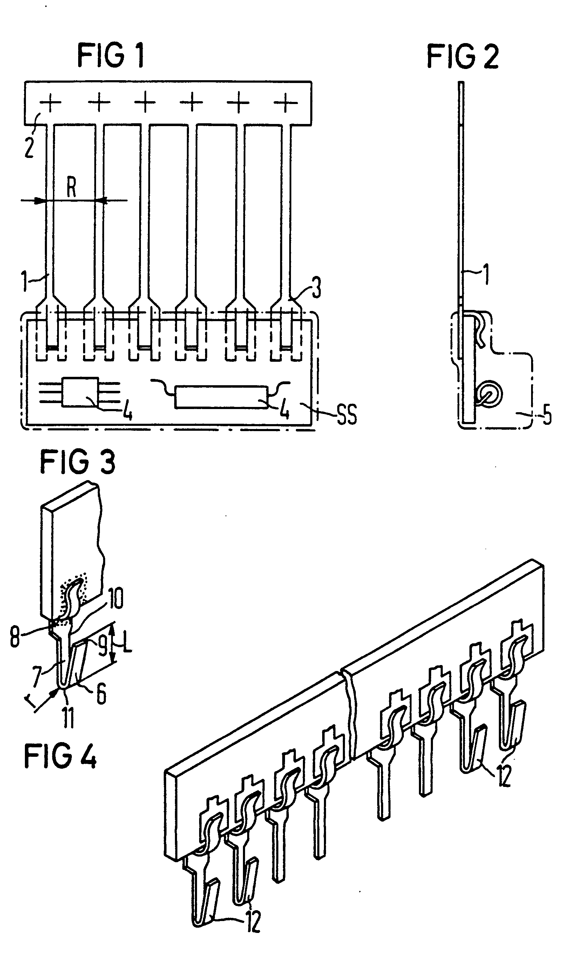

In den Figuren 1 und 2 ist die erste Stufe bei der Kontaktierung von Schichtschaltungen SS gezeigt. Der verwendete Trägerstreifen enthält eine Vielzahl an Anschlußklemmen, deren Anschlußstücke 1 über einen Steg 2 miteinander verbunden sind. An die Anschlußstücke 1 schließt sich über eine Verbreiterung die Klemmkontur 3 der Anschlußklemme an, die zum Umfassen der Anschlußteile der Schichtschaltung 55 taschenförmig aufgeweitet ist. Die Schichtschaltung kann dabei neben integrierten Schichtbauelementen auch zusätzlich diskrete Bauelemente 4 enthalten. In der Seitenansicht entsprechend Fig. 2 ist außerdem bereits die Umhüllung 5 angedeutet, die im Endzustand sowohl die Schichtschaltung als auch einen Teil der Anschlußklemme umhüllt. Der Steg 2 kann die Anschlußklemmen mehrerer Schichtschaltungen miteinander verbinden, so daß die gleichzeitige Montage mehrerer Schichtschaltungen möglich ist. Die Schichtschaltungen können in der Form entsprechend Fig. 1 mit dem Trägerstreifen in ein Lötbad eingetaucht werden, so daß gleichzeitig die Anschlußklemme 3 mit der Schichtschaltung verbunden und die Anschlußstücke verzinnt werden. Anschließend werden die sowohl mit Lötstoplack bedeckten Teile der Schichtschaltung als auch wesentliche Teile der Anschlußklemmen mit einer Umhüllung 5 versehen, die zum Schutz der Schichtschaltung dient und gleichzeitig die Verbindung zwischen den Anschlußklemmen und der Schichtschaltung unterstützt. Abschließend erfolgt das Abtrennen des Stegs 2 von den Anschlußstücken und das Umbiegen aller oder einiger der Anschlußstücke zur Erzeugung einer federnden Standhilfefunktion. Bis zum Abtrennen und damit praktisch über den gesamten Herstellungsvorgang sichert der Steg 2 den Abstand R der einzelnen Anschlußstück voneinander, der im Hinblick auf das Rastermaß der Leiterplatte genau einzuhalten ist.

In der Fig. 3 ist ein Teil einer Schichtschaltung mit einer einzelnen Anschlußklemme dargestellt, deren Anschlußstück entsprechend der Erfindung V-förmig umgebogen ist. Der Biegeradius r ist (11) beim Ausführungsbeispiel höchstens 0,1 mm, so daß ein gerundetes Anschlußende mit vorteilhaft kleinem Einführungsquerschnitt für die Leiterplattenlöcher entsteht. Der erzeugte Anschluß besteht aus einer Feder mit einem mit der Verbreiterung der Anschlußklemme verbundenen Schenkel 7 und einem freien Schenkel 6, dessen Länge L so bemessen ist, daß das freie Ende 9 oberhalb der Schulterkante 10 der Verbreiterung aber unterhalb des Lötbereichs 8 liegt. Dadurch ist einerseits die Kollision mit dem Lötbereich augeschlossen, andererseits aber gewährleistet, daß das freie Ende 9 oberhalb der Leiterplattenoberfläche liegt, da die Schulterkante 10 beim Einführen der Feder in das Leiterplattenloch als Anschlag dient.

Bei Schichtschaltungen mit einer größeren Anzahl von Anschlußklemmen ist es unnötig, die Anschlußstücke aller dieser Klemmen V-förmig umzubiegen. In diesem Falle reicht die Modifikation einiger Anschlüsse 12 entsprechend Fig. 4 aus, bei ausreichender Standhilfe ergibt sich dadurch eine nicht wesentlich erhöhte Steckkraft.

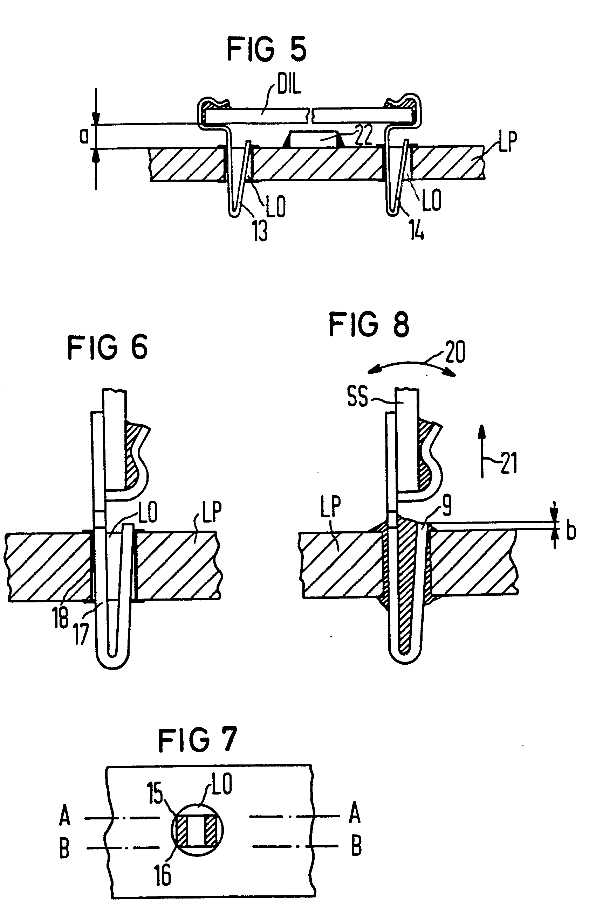

In der Figur 5 ist eine sogenannte Dual-In-Line-Schaltung DIL mit beidseitiger Kontaktierung in einer Leiterplatte LP gezeigt. Auch für die beidseitige Kontaktierung ist die Verwendung V-förmig umgebogener Anschlußstücke 13, 14 zweckmäßig, weil damit der Abstand "a" zwischen Dual-In-Line-Schaltung und Leiterplatte variable ohne Festanschlag möglich ist. Das ist vorteilhaft, wenn Bauteile 22 auf der Leiterplatte und Schichtschaltung einander nicht berühren dürfen. Die gerundeten Anschlußenden der Anschlußstücke erleichtern auch in diesem Falle wesentlich das Einführen in die Löcher LO der Leiterplatte LP. Das Umbiegen des freien Schenkels nach rechts oder nach links im Hinblick auf die Klemmkontur ist dabei frei wählbar.

In der Figur 6 ist wiederum eine Anschlußklemme mit einem V-förmig umgebogenen Anschlußstück im Loch LO einer Leiterplatte LP dargestellt. Das Loch LO der Leiterplatte ist dabei mit einer metallischen Durchkontaktierung 18 verbunden. In diesem Fall ist ein ausreichender Kontakt gegeben, der eine elektrische Verbindung von Schichtschaltung und Leiterplatte ohne Einlöten bewirkt. Aus der Aufsicht entsprechend Figur 7 ist erkennbar, daß sich zwischen dem festen Schenkel 17 des Anschlußstückes und der Durchkontaktierung 18 linienförmige Hauptkontaktstellen 15 und 16 in den Ebenen A-A bzw. B-B ausbilden. Die Schichtschaltung bleibt dabei durch Selbsthemmung in dieser Steckposition und elektrisch kontaktiert, sofern von außen keine zusätzlichen Kräfte wirksam werden.

In der Figur 8 ist die Konfiguration nach Fig. 6 nach dem Einlöten in eine Leiterplatte dargestellt. Durch die Federwirkung des umgebogenen Anschlußstückes ist die Schichtschaltung SS gegen Kippen 20 und Aufschwimmen 21 gesichert. Nach der Verfestigung des Lotes steht das Ende 9 des freien Schenkels im Abstand b über der Leiterplatte LP. Dadurch läßt sich die Schichtschaltung mit den Anschlüssen problemlos aus der Leiterplatte auslöten, da ein Verhaken des freien Schenkelendes im Leiterplattenloch nicht möglich ist.

**Patentanspruch**

Verfahren zur Herstellung einer Schichtschaltung, bei der eine Vielzahl von Anschlußklemmen, die zu einem Trägerstreifen zusammengefaßt sind, nächst auf einer Seite über eine taschenförmige Klemmkontur (3) mit Anschlußflächen der Schichtschaltung (SS) verbunden und anschließend auf der anderen Seite mit im Anschluß an eine Verbreiterung vorgesehenen bandförmigen, vergleichsweise schmaleren Anschlußstücken (1) in Rasterbohrungen (LO), einer Leiterplatte (LP) eingesteckt werden, nachdem zuvor ein Steg (2) über den die Anschlußstücke im Rasterabstand zusammenhängen, abgetrennt worden ist, dadurch gekennzeichnet, daß wenigstens einige der Anschlußstücke (1) nach dem Abtrennen des Steges (2) derart umgebogen werden, daß eine V-förmige Feder entsteht, deren freier Schenkel (6) mit seinem Ende (9) oberhalb einer als Anschlag beim Einstecken der Anschlußstücke (12, 13, 14) in die Bohrungen (LO) einer Leiterplatte (LP) wirksamen Schulterkante (10) der Verbreiterung der Anschlußklemmen (3) liegt.

**Claim**

A method for producing a film circuit in which a plurality of terminals together forming a carrier strip are initially connected to connecting faces of the film circuit (SS) by means of a pocket-shaped clamping contour (3) on one side and then inserted in grid drillings (LO) of a circuit board (LP) by means of comparatively narrower strip-shaped connecting elements (1) provided adjoining a widening on the other side once a strip (2) which joins the connecting elements (1) together with grid spacing has first been removed, characterised in that after the strip (2) is removed, at least some of the connecting elements (1) are bent over so as to form a V-shaped spring with a free limb (6) the end (9) of which lies above a shoulder edge (10) of the widening of the terminals (3) effectively forming a stop when the connecting elements (12, 13, 14) are inserted in the drillings (LO) of a circuit board (LP).

## Revendication

Procédé pour fabriquer un circuit à couches, selon lequel on relie tout d'abord, sur un côté, une multiplicité de bornes de raccordement réunies par raccordement à une bande de support, à des surfaces de raccordement du circuit à couches (SS), par l'intermédiaire d'un élément de serrage (3) en forme de poche, et on enfiche ensuite, sur l'autre côté, lesdites bornes de raccordement, au moyen de leurs éléments de raccordement (11) en forme de bandes, se raccordant à une partie élargie et possédant une forme plus étroite, dans des perçages (LO) disposés selon un réseau dans une plaquette à circuits imprimés (LP), après avoir préalablement détaché une barrette (2) au moyen de laquelle les éléments de raccordement (1) sont retenus assemblés à une distance égale au pas du réseau, caractérisé par le fait qu'après le détachement de la barrette (2), on replie au moins quelques-uns des éléments de raccordement (1) de manière à former un ressort en forme de V, dont la branche libre (6) est située au-dessus d'un bord formant épaulement (10) de la partie élargie des bornes de raccordement (3), qui agit en tant que butée lors de l'enfichage des éléments de raccordement (12, 13, 14) dans les perçages (LO) d'une plaquette à circuits imprimés (LP).

# FIG 1

# FIG 2

# FIG 3

# FIG 4

## FIG 5

## FIG 6

## FIG 8

## FIG 7